(19) Europäisches Patentamt
European Patent Office
Office européen des brevets

(11) EP 1 119 909 B1

(12) EUROPEAN PATENT SPECIFICATION

(45) Date of publication and mention
of the grant of the patent:
**14.01.2004 Bulletin 2004/03**

(51) Int Cl.$^7$: **H03H 17/02**

(86) International application number:
**PCT/SG1998/000081**

(21) Application number: **98950601.9**

(22) Date of filing: **13.10.1998**

(87) International publication number:
**WO 2000/022728 (20.04.2000 Gazette 2000/16)**

(54) **AREA EFFICIENT REALIZATION OF COEFFICIENT ARCHITECTURE FOR BIT-SERIAL FIR, IIR FILTERS AND COMBINATIONAL/SEQUENTIAL LOGIC STRUCTURE WITH ZERO LATENCY CLOCK OUTPUT**

FLÄCHENEFFIZIENTE HERSTELLUNG VON KOEFFIZIENTARCHITEKTUR FÜR BIT-SERIELLE FIR, IIR FILTER UND KOMBINATORISCHE/SEQUENTIELLE LOGISCHE STRUKTUR OHNE LATENZ

REALISATION A RENDEMENT SURFACIQUE D'UNE ARCHITECTURE DE COEFFICIENTS POUR FILTRES EN SERIE PAR BIT, RIF, RII ET STRUCTURE LOGIQUE COMBINATOIRE/SEQUENTIELLE A SORTIE D'HORLOGE A RETARD NUL

(84) Designated Contracting States:
**DE FR GB IT**

(43) Date of publication of application:
**01.08.2001 Bulletin 2001/31**

(73) Proprietors:
- **STMicroelectronics Pte Ltd.**
  **Singapore 569508 (SG)**
- **STMicroelectronics Limited**
  **Uttar Pradesh (IN)**

(72) Inventors:
- **MALIK, Rakesh, STMicroelectronics Limited**
  **Noida - 201 301, U.P. (IN)**
- **GOEL, Puneet**
  **Chandigarh 160019, Punjab (IN)**

(74) Representative: **Cerbaro, Elena, Dr. et al**
**STUDIO TORTA S.r.l.,**
**Via Viotti, 9**
**10121 Torino (IT)**

(56) References cited:
**WO-A-94/23493**

- **DAWOOD ALAM ET AL: "VLSI IMPLEMENTATION OF A NEW BIT-LEVEL PIPELINED ARCHITECTURE FOR 2-D ALLPASS DIGITAL FILTERS" 1995 IEEE INTERNATIONAL SYMPOSIUM ON CIRCUITS AND SYSTEMS (ISCAS), SEATTLE, APR. 30 - MAY 3, 1995, vol. 1, 30 April 1995, pages 724-727, XP000583315 INSTITUTE OF ELECTRICAL AND ELECTRONICS ENGINEERS**
- **K. MANIVANNAN ET AL.: "Minimal Multiplier Realization of 2-D All-Pass Digital Filters" IEEE TRANSACTIONS ON CIRCUITS AND SYSTEMS., vol. 35, no. 4, April 1988, pages 480-484, XP002104516 NEW YORK US**
- **DUNCAN P. ET AL: 'Strategies for Design Automation of High Speed Digital Filters' JOURNAL OF VLSI SIGNAL PROCESSING no. 9, 1995, DORDRECHT, NL, pages 105 - 118**

## Description

### FIELD OF THE INVENTION

The invention relates to area efficient realization of coefficient block [A] or architecture [A] with hardware sharing techniques and optimizations applied to this block. The coefficient block [A] is connected to coefficient lines (CLin_0, CLin_1.....CLin_n and BLin_0, BLin_1,....BLin_n) for performing filtering operation or a mathematical computing operation with optimization in hardware and provides a zero latency output, i.e., an output with no clock delay. The invention also gives the area minimal realization of digital filters based on coefficient block[A], when operated in bit serial fashion. The optimization techniques and structure of the present invention are good for linear digital filters typically a finite impulse response(FIR) filter, infinite impulse response filter(IIR) and for other filters and applications based on combinational logic consisting of delay element(T), multiplier(M), adder(SA) and subtractor (SS).

### Brief description of the accompanying drawings

In the accompanying drawings:

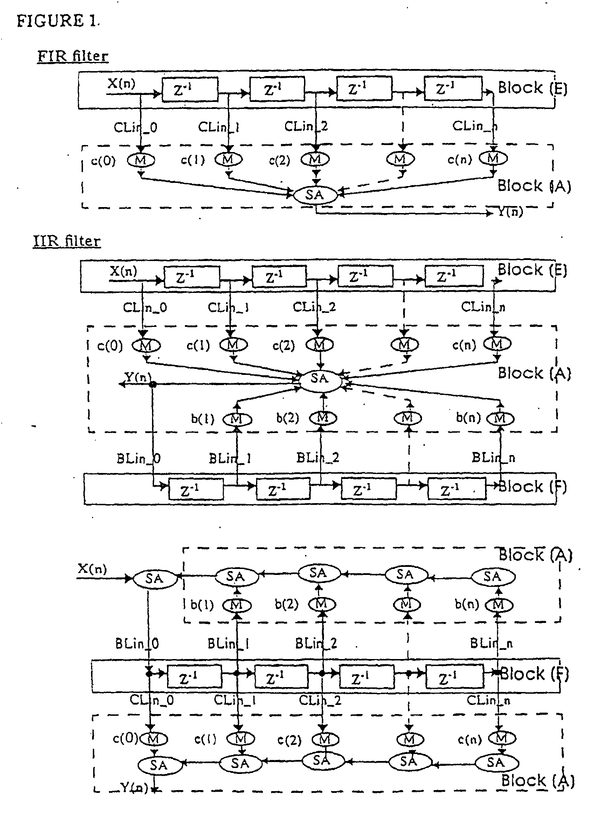

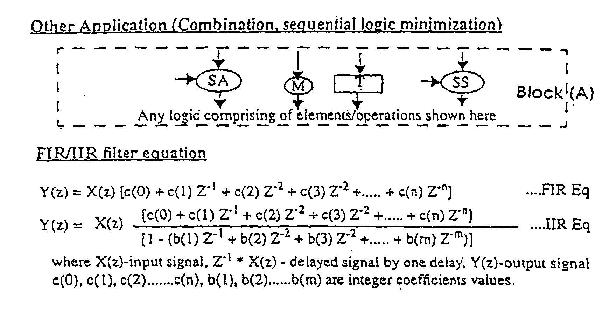

Figure 1 shows the field of invention, applications of the device
Figure 2 shows the symbol of components used in device.
Figure 3 shows the description of the components used in device.
Figure 4 shows the bit serial FIR filter implementations.
Figure 5 shows an example of FIR filter.
Figure 6 shows one of the known minimization technique due to symmetry of coefficient.
Figure 7 shows the structure of existing/known implementation technique for example FIR filter.
Figure 8 shows the generalized structure of existing/known implementation technique of coefficient block.
Figure 9 shows a realization of the coefficient block for coefficient value close to power of two.
Figure 10 shows the optimization (a) for realizing the coefficient block for example FIR filter, of the present invention.
Figure 10a shows an implementation flow of a first filter equation.
Figure 10b shows an implementation flow of a second filter equation.
Figure 11 shows the optimization (b) for realizing the coefficient block for example FIR filter, of the present invention.
Figure 12 shows the optimization (c) for realizing the coefficient block for example FIR filter, of the present invention.
Figure 13 shows the generalized optimized structure, of the present invention.

### Details of Elements/symbol used in the description

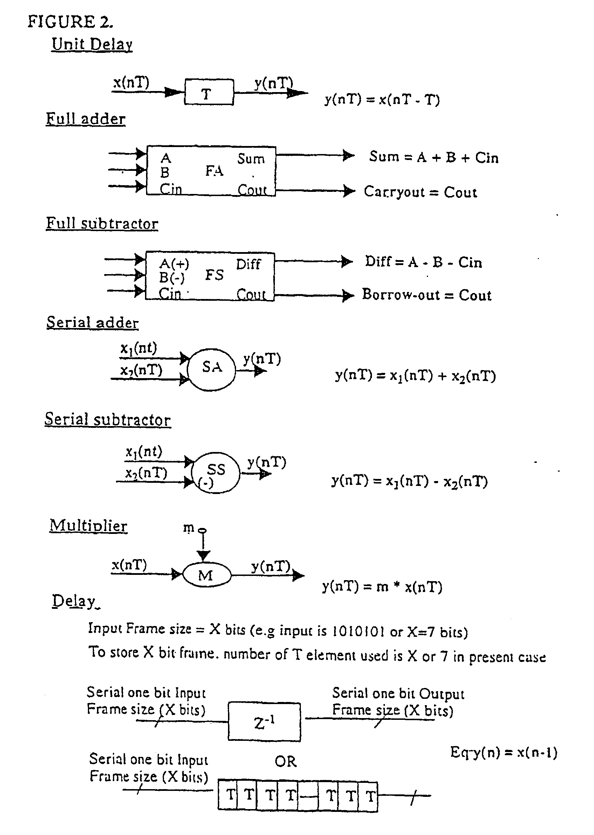

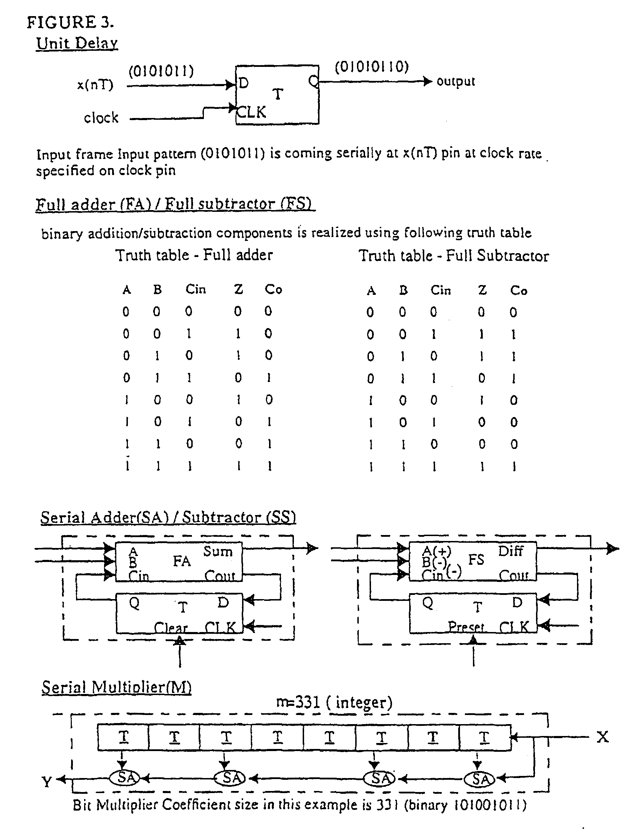

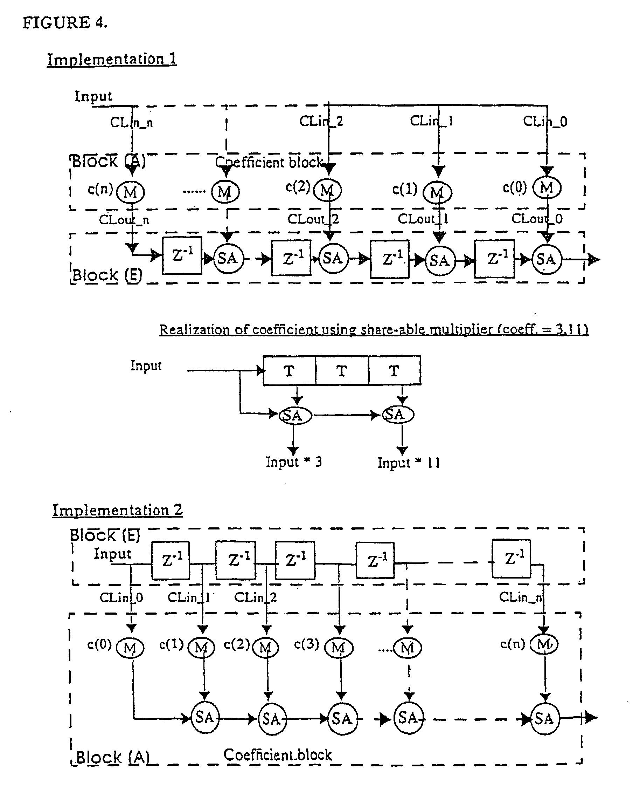

The basic components symbol used in design are shown in "Figure 2" of the drawings. In addition, explanation and usages of the device are done in the text below & depicted in "Figure 3" and "Figure 4" of the drawings.

### Unit delay (T)

It is one bit delay element. It also performs function of a multiplier by a factor of 2, e.g., for the serial input frame 0101011 in binary or 43 in integer representation, the output of this block is 01010110 in binary or 86 in integer representation. This element is usually a Flip-flop (D Flip-flop, J-K Flip-flop etc.).

### Full adder (FA)

It performs binary addition. The inputs to this element are A, B, Cin (Carryin) while the outputs are Z and Cout (Carryout). The truth table for full adder functionality is shown in "Figure 3" of the drawings.

### Full subtractor (FS)

It performs binary subtraction. The inputs to this element are A, B, Cin (Carryin) while the outputs are Z and Cout (Carryout). The truth table for full subtractor functionality is shown in "Figure 3"of the drawings.

### Serial adder (SA) and Serial Subtractor (SS)

It performs addition/subtraction of two serial frame, x1(nT), x2(nT) to generate output y(nT) represented as x1(nT)+x2(nT) or x1(nT)-x2(nT). The serial adder (or subtractor) is implemented using a full adder (or subtractor) with a Flip-Flop as shown in "Figure 3" of the drawings. The output Cout of a full adder/subtractor is delayed using the unit delay element [T] and is applied to Cin line of the full adder/subtractor. This enables the a full adder/subtractor and the unit delay element [T] together to function as serial adder (SA/SS), where A, B are the inputs to this element and Z is the output. (e.g of serial addition is as follows, if x1(nT) = 0110 (6 in integer) and x2(nT) = 0111 (7 in integer). Then y (nT) = 01101 (13 in integer representation).

### Serial Multiplier (M)

It multiplies two serial input frame X(nT) and m. The output is a function represented as Y(nT) = X(nT) * m. A serial coefficient multiplier(M) can be implemented by shift register using unit delay elements [T] and adder elements [SA] (One shift means multiply by factor of 2). As shown in "Figure 3" of the drawings, the multiplier is formed by adding the outputs corresponding to ones in the binary representation of the coefficient.

### Delay ($Z^{-1}$)

Delay by one frame of data is done by shift register (series of Flip-flops (T) connected to store and shift the input frame). The number of Unit delay (T) in one delay element is equal to the frame size of the input.

### PRIOR ART OR EXISTING IMPLEMENTATION OF FILTER

The following description discusses the elements used for implementation of design and the existing implementations for digital filters. The proposed minimization is extendable to other applications such as Digital Signal Processing field and Digital designs.

From here onwards, all the illustration will be done with the preferred embodiment namely FIR filter which is extendable to other filters as described earlier. "Figure 4" shows the existing structure of bit serial FIR filter with coefficient lines CLin_0, CLin_1,......CLin_n and the coefficient block [A] having the coefficients c(0), c(1), c(2),....c(n). The coefficient block is connected to delay element [$Z^{-1}$] and serial adders [SA] to form filter structure.

Stating the FIR filter equation in time and frequency domain

$$Y(n) = c(0) X(n) + c(1) X(n-1) + c(2) X(n-2) +.....c(n) X(0)$$

$$Y(z) = X(z) [c(0) + c(1) Z^{-1} + c(2) Z^{-2} + c(3) Z^{-3} + c(4) Z^{-4} + c(5) Z^{-5} + c(6)$$

$$Z^{-6}+.................+c(n) Z^{-n}]$$

where X, Y are the input and output respectively and c(0), c(1).....c(n) represent the coefficients value which defines the characteristics of the filter and each delay [$Z^{-1}$] block represents one sample delay. The filter equation can be implemented in two ways as shown in "Figure 4" of the drawings

In implementation 1, coefficient lines CLin_0, CLin_1,.....CLin_n are common and connected to input X[n]. The output lines CLout_0, CLout_1,......CLout_n are connected to a delay block [E], consisting of delay elements [$Z^{-1}$] and serial adders [SA]. The structure makes easy realization of share-able multiplier in the coefficient block [A]. An example of share-able multiplier with coefficient values 3,11 is illustrated in "Figure 4". The realization of these coefficients separately would require four unit delay elements and three serial adders. By virtue of coefficient lines CLin_0, CLin_1,... being common, the hardware is realized using three unit delay elements and two serial adders. Another feature of the structure is that the structure inherently requires more storage area, represented by [$Z^{-1}$], as compared to implementation 2, since the storage is done after the multiplication. For input frame of n bit and coefficient of size m bit, the storage area of each delay element [$Z^{-1}$] is (m+n). The total storage space of the delay elements is equal to (m+n) * (number of coefficients -1).

In implementation 2, the coefficient line CLin_0, CLin_1,..... are not common. By virtue of connectivity of different input lines to the coefficient elements [c(0), c(1).....], the realization of coefficient block [A] using share-able elements is not present. Another feature of this structure is that it inherently requires lesser storage space, represented as [$Z^{-1}$], as unlike in previous implementation, here the storage is done before multiplication. For input frame of m bit and coefficient of size n bit, the storage area of each delay element [$Z^{-1}$] is m. The total storage space is m* (number of coefficients -1).

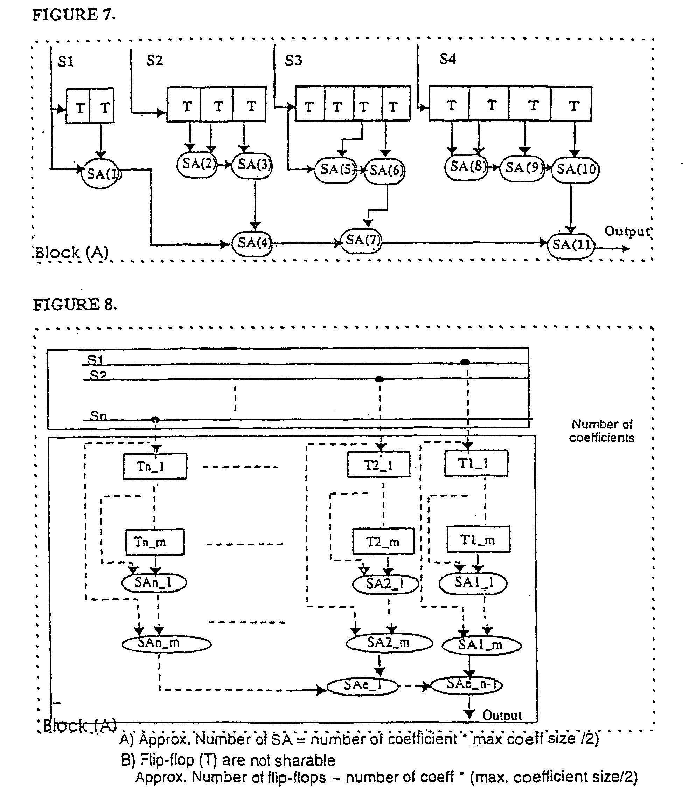

The invention reduces the hardware of the coefficient block [A] by having share-able elements in coefficients, even if the coefficient lines CLin_0, CLin_1,.....are not commonly connected. For existing configuration as .shown in "Figure 7" and "Figure 8", the share-ability of hardware in coefficient block [A] is a limitation.

Also, as described in previous section, implementation 2 is area efficient with respect to implementation1 due to reduced delay elements size. Over and above this by having share-able multiplier or reduced coefficient block [A], which are the key features of the invention, implementation 2 becomes still more area-efficient. This reduction is extendable to other filter based on coefficient block [A] as stated in the first section. The present invention operates on integer valued coefficient.

Further, to quote Norsworthy and Crochiere (Delta-Sigma Data Converters IEEE press pp-435, copyright 1997)

"Bit-serial architecture reduce the interprocessor communication down to 1 bit. Generally the number of processors is very large, but because each processor is so small, the overall economy is very high. Bit serial architectures are usually most effective for filters having a few state variables, such as IIR filters and the wave-digital filters. For this reason, bit- serial techniques are less frequently applied to FIR structures, especially when the filter length is relatively long....." .

However, the present invention applies optimization techniques for reducing the area in large sized coefficients by applying a number of optimizations in FIR/IIR filter structures

To elaborate the applicant's optimization techniques, consider an FIR filter with symmetrical coefficient as 5, 14, 25, 30, 25, 14, and 5. Though, the size of the coefficients in this example is small, it is enough to elaborate the minimization proposals. Stating the FIR filter equation in time and frequency domain

$$Y(n) = c(0) X(n) + c(1) X(n-1) + c(2) X(n-2) +.....c(n) X(0)$$

$$Y(z) = X(z) [c(0) + c(1) Z^{-1} + c(2) Z^{-2} + c(3) Z^{-3} + c(4) Z^{-4} + c(5) Z^{-5} + c(6)$$

$$Z^{-6} +.................+c(n) Z^{-n}]$$

where X, Y are the input and output respectively and c(0), c(1).....c(n) represent the coefficients value. Using the coefficient values in above equation

$$Y(n) = 5 X(n) + 14 X(n-1) + 25 X(n-2) + 30 X(n-3) + 25 X(n-4) +14 X(n-5) + 5 X(n-6)$$

$$Y(z) = X(z) [5 + 14 Z^{-1} + 25Z^{-2} + 30 Z^{-3} + 25 Z^{-4} + 14 Z^{-5} + 5 Z^{-6}] \qquad \text{(EQ 1)}$$

**The Existing Method and Minimization**

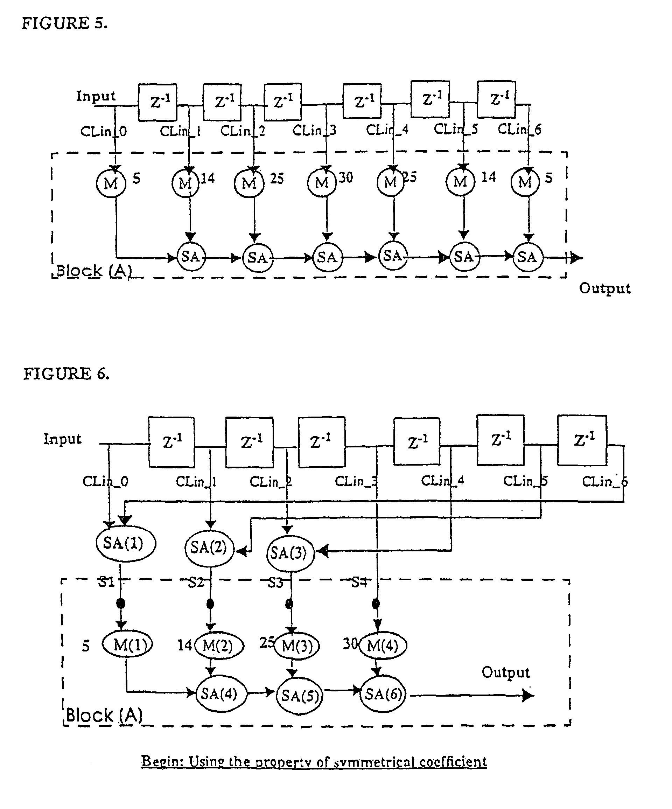

"Figure 5" of the drawings shows FIR filter structure, of implementation 2. This figure illustrates the realization of FIR filter represented by "Equation 1" .

In one of the known optimization technique, is taken advantage of the symmetry in the coefficients. The streams which have to be multiplied with the same coefficients can be added first and then multiplied. For a large filter structure, this leads to a reduction by 45% in the coefficient block [A]. (see "Figure 6" of the accompanying drawings)

This is done by restructuring the equation as under:

$$Y(z) = X(z)[5*(1+Z^{-6}) + 14*(Z^{-1}+Z^{-5}) + 25*(Z^{-2}+Z^{-4}) + 30 * Z^{-3}] \qquad \text{(EQ 2)}$$

For the rest of the optimization proposals it will be talking about only the multiplier adder series which is shown in the dotted box referred to as coefficient block [A]. "Figure 7" of the drawings shows the traditional way of implementation of the example structure for coefficient block [A], wherein S1 to S4 represent the input lines connected to delay block [$Z^{-1}$] through coefficient lines CLin_0 to CLin_6 depicted in "Figure 6" of the drawings. The input lines S1 to S4 are separately connected to a unit delay element [T] for performing a multiplication by "a factor of 2" and a serial adder (SA) is used to perform serial addition of data. This represents the multiplier less realization of filter coefficient block [A)] where the property of flip-flop (unit delay element [T]) as multiplier of two is used.

Mathematically, the restructured equation according to the structure is stated as

$$Y(nT)=(4+1)S1 + (8+4+2)S2 + (16+8+1)S3 + (16+8+4+2)S4 \qquad (EQ\ 3)$$

In this implementation, input lines S1, S2, S3, S4 are not commonly connected. Hence this restricts to achieve a share-able hardware in coefficient block [A]. Thus all the function/operations of this block represent unique hardware. The elements required by the terms are listed as

First term = two unit delay elements and one serial adder,

Second term = three unit delay elements and two serial adders,

Third term = four unit delay elements and two serial adders, and

Fourth term = four unit delay elements and three serial adders.

Final addition of all the four term would require three serial adders elements.

The generalized structure of "The Existing Method and Minimization" is depicted in "Figure 8". In the structure, each column represents a coefficient value. The unit delay elements, shown as T1_1 to T1_m in column1, defines connectivity with input line S1. In similar fashion, unit delay elements, shown as Tn_1 to Tn_m in column n, defines the connectivity with input line Sn.

The presence of one of the elements in columns 1 to n (i.e T1_1 to T1_m, T2_1 to T2_m......Tn_1 to Tn_m) is determined by coefficient value. Thus depending on coefficient value on lines S1 to Sn, the number of unit delay elements [T] in a column is determined. Also the number of serial adders/subtractors [SA/ SS] in columns is represented as (SA1_1 to SA1_m,SA2_1 to SA2_m......SAn_1 to SAn_m). The presence of one of these elements is again defined by the coefficient value.

In the structure, the unit delay elements [T] are arranged in shift register form. The input to first unit delay element is connected to one of the input line S. While the input to a serial adder or subtractor is connected from input lines S* and/or one of the output of input delay elements of shift register, depending on the coefficient value. Finally, using serial adders SAe_1 to SAe_n-1 elements, the addition/subtraction of serial adders/subtractors of all the coefficient terms depicted in columns is done. The final output is the output of last addition/subtraction.

Among the input lines S1 to Sn, the unit delay elements are not share-able and also the serial adders in each column are also not share-able. Thus limited minimization is possible in this structure.

A different existing implementation of a filter is disclosed in WO 94 23493 A, which relates to a method and an arrangement in a transposed digital FIR filter for multiplying a binary input signal by tap coefficients, and to a method for designing such a filter. The invention comprises a shift register shifting in the direction of the least significant bit and copying the most significant bit or filling in zero values. The register receives the binary input signal of the filter and has outputs for outputting the content of the desired bit positions. A plurality of bit-serial subtractor and adder elements multiply the binary input signal by N+1 different tap coefficients by combining output bits of the shift register. The subtractor and/or adder elements form a network wherein at least one element participates in the multiplying operation of at least two different tap coefficients.

Furthermore, optimization techniques for DSP circuits based on the design experience with a number of high speed digital filter chips are described in P. Duncan et al., "Strategies for Design Automation of High Speed Digital Filters", Journal of VLSI Signal Processing, Vol. 9, p. 105-119, January 1995, Kluwer Academic Publishers. These designs show that efficient high speed digital filter designs can be achieved using several optimizations at the architecture circuit and layout level. The problems of automating these optimizations in a general DSP synthesis environment are discussed and possible CAD solutions are proposed.

## DETAILED DESCRIPTION OF THE INVENTION

The device reduces the hardware of the coefficient block [A] by having share-able elements in coefficient block [A], even in the implementation where the coefficient lines CLin_0, CLin_1,.....are not commonly connected (shown as architecture [A]). This reduced hardware in coefficient block [A] when applied in implementation2 ("Figure 4") makes it still more area- efficient. This reduction is extendable to other filter based on coefficient block [A], as stated in the first section.

The device of the present invention reduces the area by approximately 30- 50% of "Figure 7" of the drawings by reducing the number of components. The optimization techniques are illustrated mathematically and towards the end of this section generalized equation and structure of the device is presented.

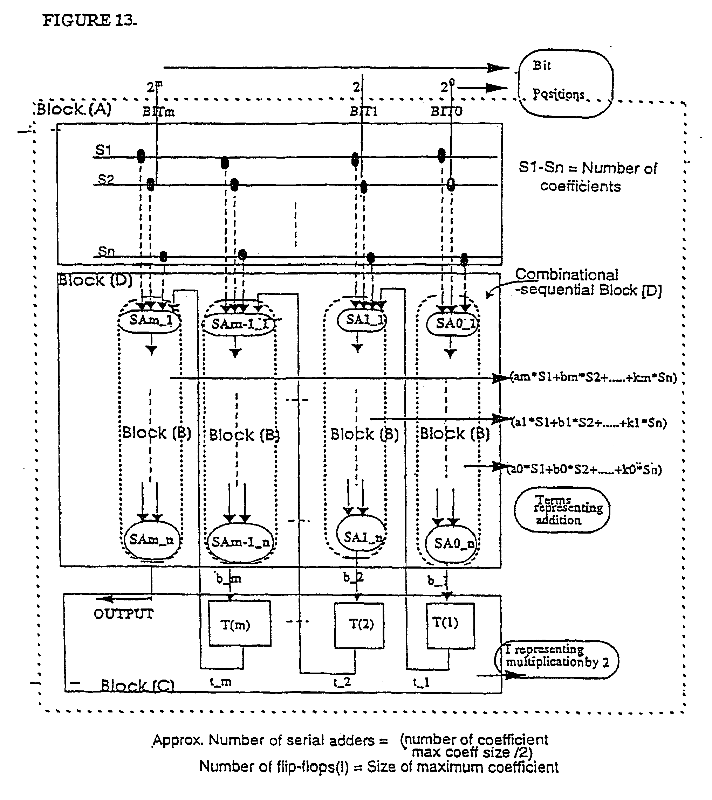

Accordingly, the present invention (Fig. 13) provides a digital logic architecture, a digital filter and a combination logic structure as claimed in claims 1, 6 and 7, respectively.

## An embodiment of the invention or Optimization (a)

Continuing the same example of FIR filter & using "Equation 3" of previous section.

$$y(nT)= 5 * S1 + 14 * S2 + 25 * S3 + 30 * S4.$$

$$Y(nT)=(4+1)S1 + (8+4+2)S2 + (16+8+1)S3 + (16+8+4+2)S4$$

we proceed to share the shift registers (multiply by 2) of the design.

$$=(S3+S4)*16+(S2+S3+S4)*8+(S1+S2+S4)*4+(S2+S4)*2+(S1+S3)$$

$$=(S1+S3)+2*(S2+S4+2*(S1+S2+S4+2*(S2+S3+S4+2*(S3+S4)))) \qquad (EQ4)$$

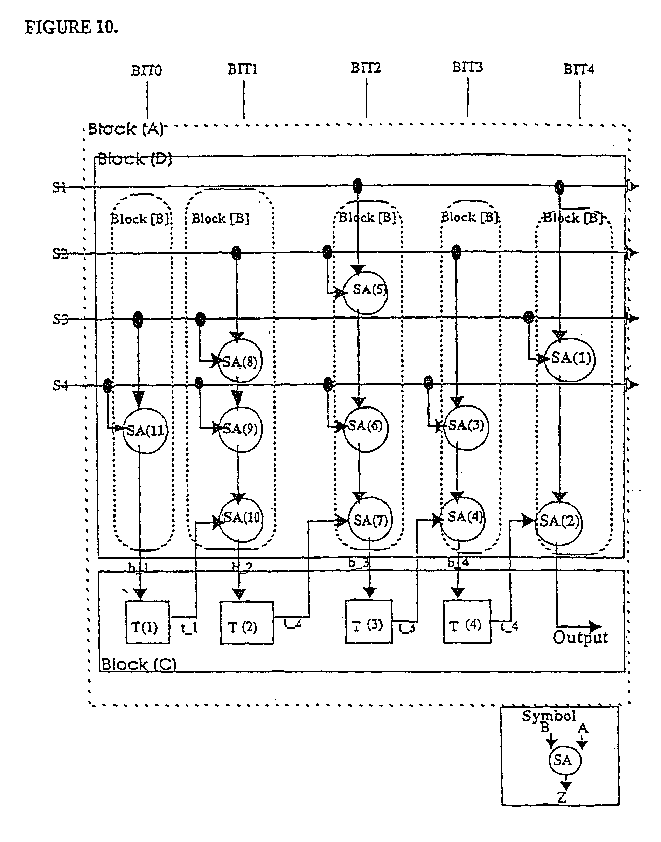

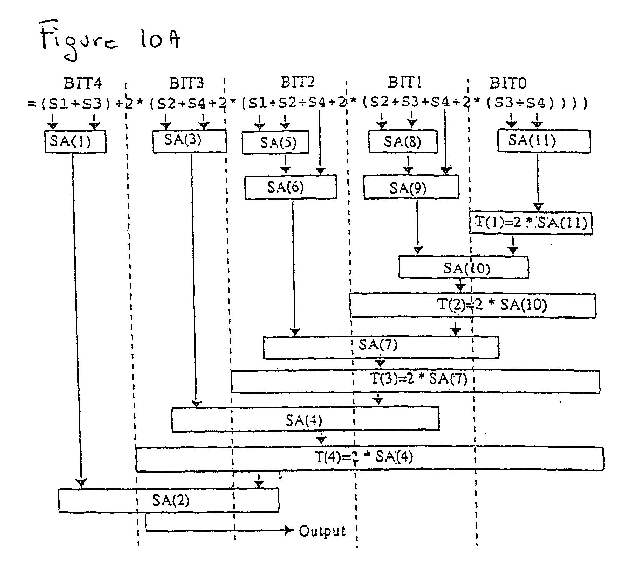

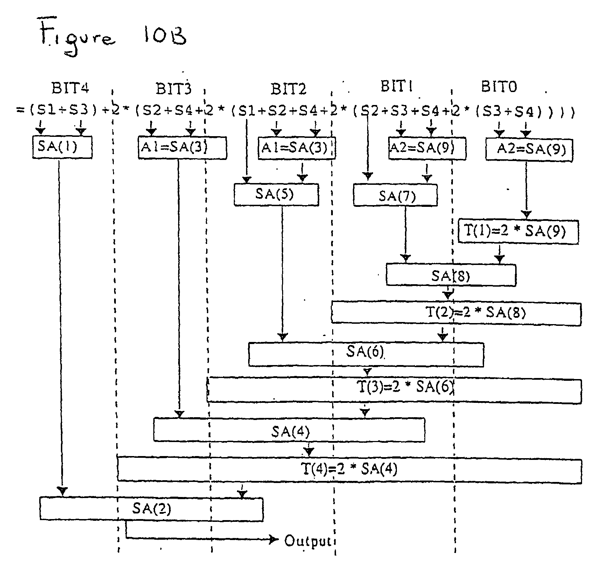

The implementation flow for this equation is presented below this text paragraph is shown, in "Figure 10" of the drawings. In the flow of implementation, S1, S2, S3, S4 represents four input lines. The primary additions are done using serial adders SA(1), SA(3), SA(5), SA(8), SA(11) representing addition of terms S1+S3, S2+S4, S1+S2, S2+S3, S3+S4. While the secondary and tertiary additions are done using the adders SA(6), SA(9), SA(10), SA(7), SA(4), SA(2). The multiplication by factor of two is done using the unit delay elements T(1), T(2), T(3), T(4).

Figure 10A shows an implementation flow of equation {optimization(a)}.

As shown in the implementation flowchart of Fig. 10A, the equation defines the bit position as BIT0 to BIT4, which is the position of "multiplication by power of two", (e.g BIT0 represents multiplication by $2^0$). At BIT0 position addition of S3+S4 is performed and the output is terminated at unit delay element T(1). The output of unit delay element T(1) defines the next bit position BIT1. which performs addition of S2+S3+S4 and output of unit delay element T(1) by using the serial adder. The output of this addition is again terminated at unit delay T(2). The structure is repeated in next BIT positions. The final addition of BIT position BIT4 gives the output of the coefficient block [A].

Implementation of hardware is shown in "Figure 10", wherein the input lines S1 to S4 represent the lines connected to delay block [$Z^{-1}$] through coefficient line Clin_0 to CLin_6 depicted in "Figure 6" of the drawings. The input lines S1 to S4 are connected to a combination logic block [B] for performing the serial addition/ subtraction, for which serial adders/subtractors are used within combination logic block[B]. The input to a combination logic block is connected to lines S1 to S4 and also from unit delay elements [T] as would be explained later in this section. The output of each combination logic block [B] is terminated with a unit delay element [T] which represents the combination logic block [B] output being multiplied by "a factor of 2". Each unit delay element [T] defines bit position marked as BIT1, BIT2, BIT3, BIT4. The output b_1 of combination logic block [B] which is at bit position BIT0 is fed to the input of the unit delay element T(1), in turn the output line t_1 of unit delay element [T(1)] is fed to next section of block[B]. The connectivity is done in similar fashion for other unit delay elements [T]. Thus all addition/subtraction in combination logic block [B] defines a bit position before getting multiplied by "a factor of 2"and changing to next bit position. The combination logic block [B] at final bit position represents the output of the coefficient block [B].

In the structure, all unit delay elements [T] are represented as a unit delay cluster [C] wherein the unit delay element [T] representing multiplication by "a factor of 2", is share-able among various coefficient values and their number is determined by maximum coefficient value. This is in contrast to "Figure 7" of existing structure where the elements are not share-able between S1 to S4 lines.

The number of unit delay elements (T) in "Figure 7" is 13 vs. number of unit delay elements (T) (flip-flops) in current proposal is 4. Also for both the implementation, the number of the one-bit serial adders (SA) remains the same [11 in each case]. In present minimization, approximate area calculations is = 11 serial adders + 4 unit delay elements = 26 Units, whereas the area after previous minimization is 11 serial adders + 13 unit delay elements = 35 units. (assuming 1 Unit = 1 full adder = 2 half adder = 1 unit delay element and a serial adder/serial subtractor (SA/SS) = 2 Units).

This is approximately 26%saving in area in "Figure 10" as compared to "Figure 7".

For filter having large size coefficient, this leads to a drastic reduction in the area (30-50% of the coefficient block).

**Another embodiment of the invention or Optimization (b)**

This optimisation reduces the hardware of block [D] which essentially consists of serial adders (SA) and serial subtractors (SS). Beginning with "Equation 4" and finding out the common additive factors

$$A1 = S2+S4$$

$$A2 = S3+S4$$

The "Equation 4" can be further reduced as

$$y(nT) = (S1+S3)+2*(A1+2*(S1+A1+2*(S2+A2+2*A2)))) \quad\quad (EQ\ 5)$$

The flow of implementation of equation is illustrated below and is self explanatory. Here S1, S2, S3, S4 represents four input lines. The primary addition is done using serial adders SA(1), SA(3), SA(9) representing addition of terms S1+S3, S2+S4, S3+S4. While the secondary and tertiary addition is done using the adders SA(5), SA(7), SA(8), SA(6), SA(4), SA(2). The multiplication by factor of two is done using the unit delay elements T(1), T(2), T(3), T(4).

Figure 10B shows an implementation flow of equation {optimization(b)}.

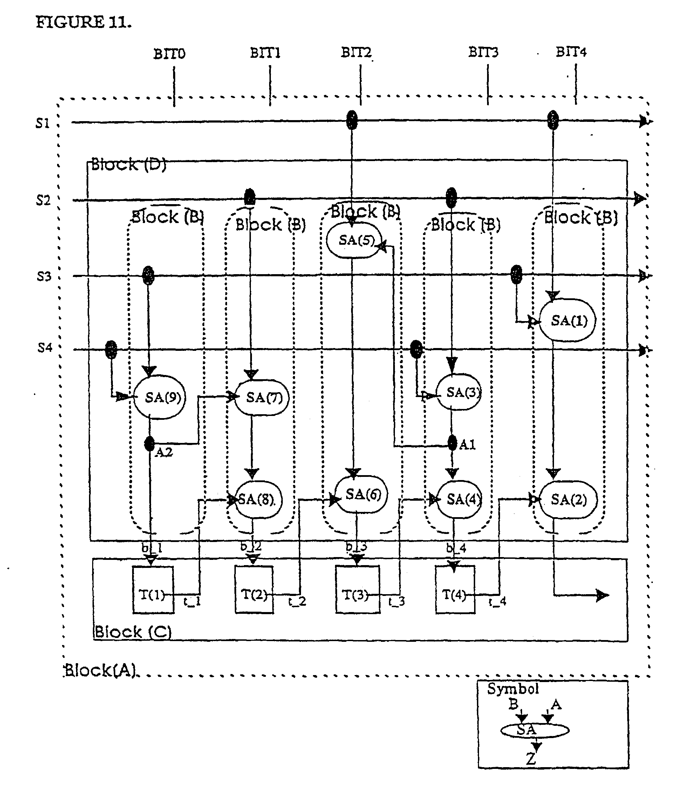

"Figure 11" shows the implementation of the structure, wherein the input lines S1 to S4 represent the lines, connected to delay block [Z$^{-1}$] through coefficient lines Clin_0 to CLin_6-depicted in "Figure 6" of the drawings. The input lines S1 to S4 are connected to combination logic block [B] for performing the serial addition/subtraction, for which serial adders/subtractors are used within combination logic block [B]. The input to combination logic block is from line S1 to S4 and also from unit delay elements [T]. The output of each combination logic block [B] is terminated with a unit delay element [T], which represents the combination logic block [B] output being multiplied by factor of 2. The output b_1 of combination logic block [B] which is at bit position BIT0, is fed to the input of the unit delay element T(1), in turn the output t_1 of [T(1)] is fed to next section of combination logic block[B]. Thus all addition defines a bit position before getting multiplied by factor of 2. All such unit delay [T] termination is represented by unit delay cluster [C].

The optimizations in reducing the hardware of combination logic cluster [D] are done. The output b_1 representing the bit position BIT0 and addition term A2, is connected to unit delay element T[1] and also fed to the next combination logic block [B], hence reducing the adder count by 1. Also the output of adders SA(3) of combination logic block [B] in bit position BIT3, is fed at two points. One to the input of adders SA(4) which eventually terminates at unit delay element [T4] and other to the input of adder SA(5), hence reducing the adder count further by 1. Note how A1 and A2 are shared in the Structure. Comparing the hardware implementation of "Figure 10" and "Figure 11", the number of adders are minimized by having common adders A1, A2. This optimization is purely dependent on finding common addition terms among coefficients.

In present minimization, approximate area calculations is = 9 serial adders (SA) + 4 unit delay elements = 22 Units, whereas the area of the existing minimization of "Figure 7" is 11 serial adder + 13 unit delay elements = 35 units. (assuming 1 Unit = 1 full adder = 2 half adder = 1 unit delay element and a serial adder (SA) = 2 Units). Thus compared to the existing minimization, the "Optimization (a)" and "Optimization (b)" , combined has resulted in 37% saving in area (13 / 35 * 100). "Optimization (b)" is an improvement of 15% in area (of the coefficient block) over "Optimization (a)"

**Yet another embodiment of the invention or Optimization (c)**

In realization of combination logic cluster [D], further optimization is done by realizing the coefficient value using subtraction instead of addition. This is good for numbers which have values closer to power of 2. (e.g. for realization of coefficient value 63, the realization (63=64 -1) is better than (63 = 32+16+8+4+2+1). In first case the number of subtractor is 1 while in second case the number of adders are 5.

To illustrate this by an example, consider the coefficient values as 5, 25, -48, -63). Writing the FIR equation using these coefficient values.

Arranging the terms with 63 as (32+16+8+4+2+1):

$$y(nT)= 5 * S1 + 25 * S2 - 48 * S3 - 63 * S4$$

$$= (1+4)*S1 + (16+8+1)*S2 - (32+16)*S3 - (32+16+8+4+2+1)*S4$$

$$=(S1+S2-S4)+2*(-S4+2*(S1-S4+2*(S2-S4-2*(S2-S4-(S3+2(S3+S4)))))) \quad\quad (EQ\ 6)$$

Alternately arranging the terms with 63 as (64 -1), the first equation reduces

$$=(1+4)*S1 + (16+8+1)*S2 - (32+16)*S3 + (1-64)*S4$$

$$=(S1+S2+S4)+2*(2*(S1+2*(S2+2*(S2-S3-2*(S3+2*S4))))) \qquad (EQ\ 7)$$

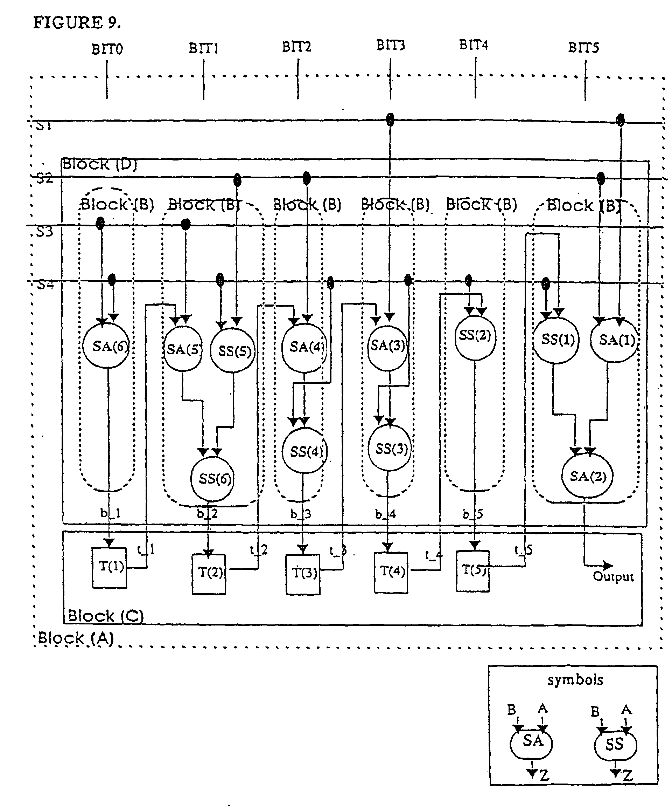

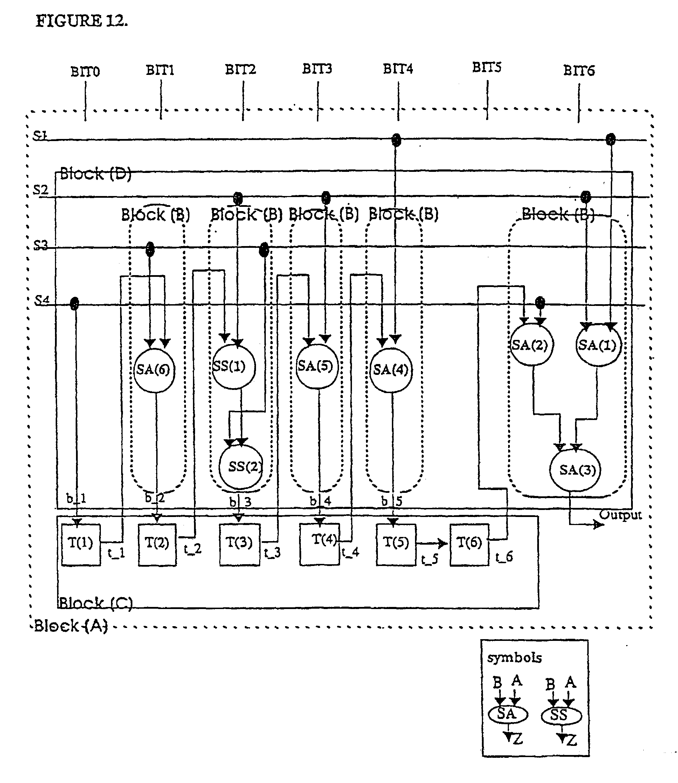

The realization of "Equation 6" and "Equation 7" is shown in "Figure 9" and "Figure 12" respectively.

In these realizations, the number of unit delay elements [T] is one more in "Equation 7" due to presence of term "64". However, the number of adders are less in the structure represented by "Equation 7" than by "Equation 6" . This is because the number of adders are less in former case.Comparing the area of the two realization. From "Equation 6" , Area obtained is 5 unit delay elements + 6 serial adders + 6 serial subtractors = 29 Units. While from "Equation 7", representing optimization(c), results an area calculation of = 6 unit delay elements + 6 serial adders + 2 subtractors = 22 Units. (assuming 1 Unit = 1 full adder = 2 half adder = 1 unit delay element and serial adder=serial subtractor= 2 Units). This is an improvement by 24% in reducing area of coefficient block for the current example.

Thus, the optimization reduces area for realization of negative coefficient. This optimization is also efficient realization of coefficients having value close to power of two. Further minimization is possible by taking subtraction as common factor and using addition instead of subtraction wherever possible in the realization. This result in an improvement in area, due to the fact that area for a subtractor is more than the area of an adder.

**GENERALIZED STRUCTURE OF THE INVENTION**

The invention provides an area efficient realization of filter coefficient block[A] applicable to filters devices such as FIR, IIR and other filter structures). This architecture is also applicable to combinational and sequential logic consisting of adder, subtractors, multipliers and unit delay elements [T]. This architecture is realized using the elements serial adders (SA), serial subtractors (SS) and unit delay elements [T] (flip-flop). Generalized structure of the present invention is depicted in "Figure 13". The generalized equation of the structure is also calculated here.

Beginning with the generalized equation of FIR filter coefficient block(A)

$$y(nT) = a * S1 + b * S2 + c* S3 +................k * Sn..........(1)$$

where a, b,....k represents filter coefficients. S1, S2..... represents input lines corresponding to the coefficients.

Now, representing each coefficient as addition of terms arranged in power of two and applying it to the equation:

$$y(nT) = (2^m*am +......2^1*a1+2^0*a0) * S1 + (2^m*bm +......2^1*b1+2^0*b0) * S2 +$$

$$(2^m*cm +......2^1*c1+2^0*c0) * S3+.....+(2^m*km+.....2^{-1}*k1+2^0*k0) * Sn$$

Further, taking "2" as common factor we get the generalized equation for architecture as:

$$Y(nT) = (a0*S1+b0*S2+....+k0*Sn)$$

$$+ 2^1 ( (a1*S1+b1*S2+....+k1*Sn) +$$

$$2^1 ((a2*S1+b2*S2+...+k2*Sn)+$$

$$2^1((a3*S1+b3*S2+...+k3*Sn)+.....+$$

$$2^1 ((am*S1+bm*S2+.....+km*Sn)))))$$

where a0, a1,.....am and b0, b1,...bm and k0, k1,.......km represents the sign of coefficients [i.e they have value (+ / - 1) or 0]. The architecture realization in "Figure 13" is done using the sequential elements like unit delays [T] and combinational elements such as serial adders (SA) and serial subtractors (SS). The highlights of the architecture are:

1) common share-able unit delay elements [T] for all the coefficients. The maximum number of unit delay elements [T] is equal to next integer value of "log of the maximum value of coefficient" in the coefficient block [A]

2) Area-optimizations in reducing the combination logic cluster [D] (i.e optimizations applied on serial adders(SA), serial subtractors (SS) as stated in previous section).

In "Figure 13", the input serial data is present on input line S1, S2,.....Sn [where n represents the number of coefficients of the filter] The addition terms of the equation.[(a0*S1+b0*S2+....+k0*Sn),(a1*S1+b1*S2+.....+k1*Sn)........(am*S1+b m*S2+.......+km*Sn)] are represented as combination logic blocks [B]. Combination logic block [B] is a combinational-sequential block consisting of serial adders (SA) and serial subtractors (SS). Since the values a0, b0,...., etc. represents value [(+ / -)1 or 0]. The connection of serial adders /subtractors to S1, S2....Sn lines and interconnection of the serial adders/subtractors depend on the value of coefficients [This is because the value of coefficient determines the value of a0, a1,......etc. and, hence it defines the interconnections between them]. The output of each combination logic block [B] is multiplied by two using unit delay elements [T] {The unit delay elements T[1], T[2],..... T[m] are used for multiplication by factor of 2}. The number of unit delay elements [T] depends on the size of maximum coefficient and is share-able for all the coefficient in the coefficient block [A]. Thus in the structure the final outputs of all the combination logic blocks [B] are terminated at unit delay elements [T] (connected through b_1, b_2,....b_m).

In the structure, all the combination logic blocks [B] are clustered together as a combination logic cluster [D] and all the unit delay elements {T[1], T[2]......T[m]} are clustered together in a unit delay cluster [C]. The unit delay cluster [C] and combination logic cluster [D] are quite separated in this architecture. The input of the unit delay element [T] is final output of combination logic block [B] and the output of unit delay element [T] is connected to the one of the inputs of combination logic block [B] of next bit position (i.e connected to input of serial adders or subtractors of combination logic block [B] depending upon the sign value+/-). The interconnections from cluster [C] to [D] is represented as t_1, t_2,.....t_m. The bit positions of serial data frame are marked as BIT0, BIT1,.....BITm.

In the generalized structure, flip-flops[T] of all the coefficient are share-able and the number of flip-flops[T] are limited to the coefficient which has the maximum value. Also optimization can be applied in block [D]. The gain in area when compared with the existing design is illustrated below.

**Hardware reduction in block [C]**

Before beginning to prove the statement, we proceed to formularize the calculation of number of flip-flop (T) for structure of "The Existing Method & Minimization" in "Figure 7" and "Figure 8" of the drawings. The number of flip-flops in the coefficient block [A], depends on the size of all the coefficients. The approximate and pessimistic formula for calculation of total flip-flops (T) in coeff. block [A] is [= average size of coefficient * number of coefficient], where average size of coefficient can be calculated pessimistically as (Maximum coefficient size / 2). (Refer "The Existing Method and Minimization", "Figure 8" of the drawings). Applying this formula, to example of "Figure 7" for verification, where coefficient (5, 14, 25, 30) are represented in 4,5,6,6 bits (using signed notation). According to formula, average size of coefficient is (6 / 2) = 3 and total number of flip-flop = 3 * 4 = 12. This is pessimistic as compared to the implementation (where total number of flip-flops are 13, refer "Figure 7").

Similarly, the approximate formula for calculation of total adders (SA) in coeff. block for "The Existing Method and Minimization", and "Detailed Description of the Invention" in "Figure 8" and "Figure 13" is [=adders per coefficient * number of coefficient]. Adders per coefficient solely depend on the value of coefficient. Assuming number of adders as (=number of coefficients * maximum coefficient size /2).

Now, as an example, the Applicants provide herebelow use of the above mentioned formulae of previous two paragraphs in filter of 20 coefficient. Assume the maximum coefficient value is represented in 16 bits (e.g. maximum coefficient value is +32767 or -32768 in 2's complement representation). Average size of the coefficient approximated by the formula is (16/2=8 bit). In "The Existing Method and Minimization", the total number of flip-flop (T) required for implementation is 8 * 20 = 160. In contrast to this "Detailed Description of the Invention" would require only 16 Flip-Flops (The number of flip-flops of all the coefficient are share- able and are limited to the coefficient which has the maximum value). Assuming in worst case that there is no optimization of adders, the number of adders in both the cases are same and are equal to 8 * 20 = 160. (Refer "Figure 8" and "Figure 13" of the drawings)

Area calculation for "The Existing Method and Minimization", "Figure 8" of the drawings is 160 unit delay elements + 160 serial adders = 480. Area calculation for "Detailed Description of the Invention", "Figure 13" is 16 unit delay elements + 160 serial adders = 336. This is an improvement of 30% [(480-336)/480] over "The Existing Method and Minimization". (assuming 1 Unit = 1 full adder = 2 half adders = 1 unit delay element and serial adder/serial subtractor (SA/SS) = 2 Units). The area gain by structure could be as high as 50% (of the coefficient block) for big filter where minimization of adders and other minimization optimization(a), optimization(b) and optimization(c), as discussed earlier, are applied.

The preferred embodiment of the invention is also supported by a real example of filter coefficient device. This is referred to as optimization(a) and shown in "Figure 10" of the drawings and discussed in previous section. Area calculation for "Figure 10" is 11 serial adders+4 unit delay elements=26 units while area of "Figure 7" of the drawings (existing implementation) is 11 serial adders + 13 unit delay elements= 35 units. This results a gain of 26% in area (of coefficient design block) for this example design as compared to existing implementation, supporting the generalized statement.

**Hardware reduction in block [D]**

The optimizations in combination logic cluster [D] are referred to as optimization (b), optimization (c) and shown in "Figure 11"; "Figure 12" of the drawings. In optimization (b), beside sharing the flip-flop (T) for all the coefficients and sharing the common adders (SA) techniques is done in combination logic cluster [D]. This is due to presence of serial adders, serial subtractors in combination logic cluster [D] and separate clustering of elements in combination logic cluster [D] and unit delay cluster [C].

This is illustrated using the example of previous section Using A1 = S2+S4, A2 = S3+S4 in this example. Total area for this example after the optimization is 9 serial adders+4 unit delay elements=22 Units. This, when combined with optimization(a) results in area-gain of 37% in area (of coefficient design block) for this example design as compared to existing implementation (where area was 35 units).

The optimization(c) as described before can be further applied to combination logic cluster [D]. That is beside optimization(a) and optimization(b), the technique of realizing the coefficient value using subtraction (SS) instead of addition (SA) is used here. This saves quite in area when the coefficient value is close to power of 2. (e.g. for realization of coefficient value 63, the realization (63=64-1) is better than (63=32+16+8+4+2+1). In first case the number of subtractor is 1 while in second case the number of adders are 5.). The two cases are illustrated in previous section with example and are shown in "Figure 12" and "Figure 9" of the drawings. The area calculation without optimization and using adders ("Figure 9" of the drawings) = 29 Units. While optimization applied ("Figure 12" of the drawings) results in area =22 Units. This is an improvement by 24% in reducing the area of coefficient block for this example.

With all the optimization applied, the invention while in use results in an area improvement of 30-50% of the coefficient block design or combinational logic consisting of adders, subtractor, multiplier and unit delays [T].

The input to adders in combination logic blocks [B] are interchangeable e.g. adders SA(5), SA(6) inputs could be interchanged. Also the signals t_1, t_2 etc. can be connected to any input of adders of combination logic block [B] of next bit position.

For approximate area calculation following assumption is made (1 Unit of Area = 1 full adder = 2 half adder = 1 unit delay element & SA serial adder = SS subtractors = 2 Units of Area).

The present invention is most economical in terms of area of coefficient block/architecture. In fact, the present invention provides an area improvement of 30-50% of the coefficient block design or combinational logic consisting of adders, subtractor, multiplier and unit delays.

**Claims**

1. A digital logic architecture for realization of coefficients for a digital filter or for a combination/sequential logic structure performing operations such as additions and/or subtractions and/or multiplications and/or delays, said digital logic architecture comprising:

   - $n$ serial coefficient input lines (S1, S2, ..., Sn), where n is the number of coefficients to be realized; and
   - a coefficient block (A) receiving inputs from the $n$ coefficient input lines (S1, S2, ..., Sn) and providing an output;

   said coefficient block (A) comprising:

   - a combination logic cluster (D) having $m+1$ combination logic blocks (B0, B1, ..., Bm), where $m$ is an integer determined as the value of $\log_2$ of the maximum coefficient value rounded up to the next integer value, said combination logic blocks receiving inputs from the coefficient input lines (S1, S2, ..., Sn), and performing addition and/or subtraction of the inputs from the coefficient input lines (S1, S2, ..., Sn) to respectively generate output terms a0·S1+b0·S2+...+k0·Sn, a1·S1+b1·S2, ..., k1·Sn, ..., am·S1+bm·S2+...+km·Sn, wherein each of a0, b0, ..., k0; a1, b1, ..., k1; ...; am, bm, ..., km has the value *1, -1 or 0, and S1, S2, ..., Sn are the inputs from the coefficient input lines; and
   - a unit delay cluster (C) having $m$ unit delay elements (T(1), T(2), ..., T(m)), the $i$-th unit delay element, with $i$ = 1...$m$, receiving as input the output term from the ($i$-1)-th combination logic block (B0, B1, ..., Bm), multiplying the received input by a factor of two, and outputting the resultant product to an input of the $i$-th combination logic block (B1, B2, ..., Bm);

   wherein the output of the coefficient block (A) is provided directly from the $m$-th combination logic block (Bm) without passing through a unit delay element.

2. A digital logic architecture as claim in claim 1, wherein said combination logic blocks (B0, B1, ..., Bm) are arranged as a matrix of ($m+1$) x $n$ order.

3.  A digital logic architecture as claim in claim 1, wherein said combination logic blocks (B0, B1, ..., Bm) each have one or more adders (SA) or subtractors (SS).

4.  A digital logic architecture as claimed in claim 3, wherein one or more interconnections are provided between one of the adders and/or subtractors of the combination logic blocks (B0 B1, ..., Bm) for sharing the adders and/or subtractors according to said one or more interconnections respectively and thus minimising the number of adders and/or subtractors required for implementation of the digital filter or the combination/sequential logic structure and consequently minimising an area of said digital logic architecture on which said combination logic blocks (B0 B1, ..., Bm) are disposed.

5.  A digital logic architecture as claim in claim 3, wherein when one of the coefficients to be realised is close to, but less than, a power of two, one or more serial subtractors are used to generate said coefficient.

6.  A digital filter comprising a digital logic architecture realizing filter coefficients, wherein said digital logic architecture is a digital logic architecture as claimed in any one of the foregoing claims 1 to 5.

7.  A combination/sequential logic structure for performing operations such as additions and/or subtractions and/or multiplications and/or delays, said combination/sequential logic structure comprising a digital logic architecture realizing coefficients for performing said operations, wherein said digital logic architecture is a digital logic architecture as claimed in any one of the foregoing claims 1 to 5.


**Patentansprüche**

1.  Digitale Logikarchitektur zur Realisierung von Koeffizienten für ein Digitalfilter oder für eine Kombinations-/Sequentiell-Logikstruktur, welche Vorgänge wie Additionen und/oder Subtraktionen und/oder Multiplikationen und/oder Verzögerungen ausführt, wobei die digitale Logikarchitektur folgendes umfasst:

    -   n serielle Koeffizienten- Eingabeleitungen (S1, S2, ..., Sn), wobei n die Anzahl der zu realisierenden Koeffizienten ist; und

    -   einen Koeffizientenblock (A), welcher Eingaben von den n Koeffizienten- Eingabeleitungen (S1, S2,..., Sn) entgegen nimmt und eine Ausgabe liefert;

    wobei der Koeffizientenblock (A) folgendes umfasst:

    -   eine Kombinationslogik- Cluster (D), welche $m+1$ Kombinationslogik- Blöcke (B0, B1,...,Bm) aufweist, wobei m eine ganze Zahl ist, welche als der Wert von $\log_2$ des maximalen Koeffizientenwertes bestimmt ist, welcher auf den nächsten ganzzahligen Wert aufgerundet ist, wobei die Kombinationslogik- Blöcke Eingaben von den Koeffizienten-Eingabeleitungen (S1, S2,...,Sn) erhalten und eine Addition und/oder Subtraktion der Eingaben von den Koeffizienten- Eingabeleitungen (S1, S2,..., Sn) ausführen, um entsprechend Ausgabenterme a0·S1+b0·S2+...+k0·Sn, a1·S1+b1·S2, ..., k1·Sn, ..., am·S1+bm·S2+...+km·Sn zu erzeugen, wobei a0, b0, ..., k0; a1, b1, ..., k1; ...;am, bm, ..., km alle den Wert *1, -1 oder 0 aufweisen und S1, S2, ...,Sn die Eingaben der Koeffizienten-Eingabeleitungen sind; und

    -   eine Einheitsverzögerungscluster ( C), welche
        m Einheitsverzögerungselemente (T(1), T2,..., T(m)), das i-th Einheitsverzögerungselement aufweist, wobei i=1...m ist,
        welche als Eingabe den Ausgabeterm aus dem (i-1 ) -th Kombinationslogik- Block (B0, B1,..., Bm) empfängt,
        die empfangene Eingabe mit einem Faktor von zwei multipliziert, und
        das sich ergebende Produkt an einen Eingang des i-th Kombinationslogik- Blocks (B1, B2,..., Bm) ausgibt;

    wobei die Ausgabe des Koeffizientenblocks (A) direkt vom m-th Kombinationslogik- Block (Bm) geliefert wird, ohne durch ein Einheitsverzögerungselement zu gehen.

**2.** Digitale Logikarchitektur nach Anspruch 1, wobei die Kombinationslogik- Blöcke (B0, B1,..., Bm) als Matrix der (m+1)x n Reihenfolge angeordnet sind.

**3.** Digitale Logikarchitektur nach Anspruch 1, wobei die Kombinationslogik- Blöcke (B0, B1,..., Bm) jeweils einen oder mehrere Addierer (SA) und/oder Subtrahierer (SS) aufweisen.

**4.** Digitale Logikarchitektur nach Anspruch 3, wobei eine oder mehrere Zwischenverbindungen zwischen einem der Addierer und/oder Subtrahierer der Kombinationslogik-Blöcke (B0, B1,..., Bm) zum Aufteilen der Addierer und/ oder Subtrahierer auf die eine bzw. die mehreren Zwischenverbindungen vorgesehen sind und somit die Anzahl an Addierern und/oder Subtrahieren minimieren, welche zur Implementierung des Digitalfilters oder der Kombinations-Sequentiell-Logikstruktur benötigt werden, und folglich einen Bereich der digitalen Logikarchitektur minimieren, auf welchem die Kombinationslogik- Blöcke (B0, B1,..., Bm) angeordnet sind.

**5.** Digitale Logikarchitektur nach Anspruch 3, wobei, wenn einer der zu realisierenden Koeffizienten nahe einer, aber weniger als eine Potenz von 2 ist, ein oder mehrere serielle Subtrahierer angewendet werden, um den Koeffizienten zu erzeugen.

**6.** Digitalfilter, welcher eine digitale Logikarchitektur umfasst, welche Filterkoeffizienten realisiert, wobei die digitale Logikarchitektur eine digitale Logikarchitektur nach einem der vorangehenden Ansprüche 1 bis 5 ist.

**7.** Kombinations-/Sequentiell-Logikstruktur zum Ausführen von Vorgängen wie Additionen und/oder Subtraktionen und/oder Multiplikationen und/oder Verzögerungen, wobei die digitale Logikarchitektur eine digitale Logikarchitektur umfasst, welche Koeffizienten zur Ausführung der Vorgänge realisiert, wobei die digitale Logikarchitektur eine digitale Logikarchitektur nach einem der vorangehenden Ansprüche 1 bis 5 ist.

**Revendications**

**1.** Dispositif logique numérique destiné à produire des coefficients pour un filtre numérique ou pour une structure à logique combinatoire/séquentielle réalisant des opérations telles que des additions et/ou des soustractions et/ou des multiplications et/ou des opérations de génération de retard, ledit dispositif logique numérique comprenant :

- n lignes d'entrée de coefficient en série (S1, S2..., Sn), où n représente le nombre de coefficients à produire ; et
- un bloc de coefficient (A) recevant des entrées des n lignes d'entrée de coefficient (S1, S2..., Sn) et délivrant une sortie ;

    ledit bloc de coefficient (A) comprenant :

- un groupe de logique combinatoire (D) comportant m+1 blocs de logique combinatoire (B0 B1, ..., Bm), où m est un nombre entier déterminé comme la valeur du $\log_2$ de la valeur de coefficient maximum arrondie à la valeur entière suivante, lesdits blocs de logique combinatoire recevant des entrées des lignes d'entrée de coefficient (S1, S2..., Sn), et exécutant l'addition et/ou la soustraction des entrées à partir des lignes d'entrée de coefficient (S1, S2..., Sn) afin de produire respectivement des termes de sortie a0.S1+b0.S2+... +k0.Sn a1.S1+b1.S2, ..., k1.Sn, ..., am.S1+bm.S2+ ... +km.Sn, dans lesquels chacun de a0, b0..., k0 ; a1, b1, ..., k1 ; ... ; am, bm, ..., km présente la valeur de 1, -1 ou 0, et S1, S2..., Sn sont les entrées des lignes d'entrée de coefficient ; et
- un groupe de retard unitaire (C) comportant m éléments à retard unitaire (T(1), T(2), ..., T(m)), le $i^{\text{ème}}$ élément à retard unitaire, avec i = 1, ..., m, recevant en tant qu'entrée, les termes de sortie du $(i- 1)^{\text{ème}}$ bloc de logique combinatoire (B0 B1, ..., Bm), multipliant l'entrée reçue par un facteur de deux, et délivrant le produit résultant sur une entrée du $i^{\text{ème}}$ bloc de logique combinatoire (B1, B2, ..., Bm) ;

    dans lequel la sortie du bloc de coefficient (A) est délivrée directement à partir du $m^{\text{ème}}$ bloc de logique combinatoire (Bm) sans passer à travers un élément à retard unitaire.

**2.** Dispositif logique numérique selon la revendication 1, dans lequel lesdits blocs de logique combinatoire (B0, B1, ..., Bm) sont agencés comme une matrice d'ordre (m+1)xn.

**3.** Dispositif logique numérique selon la revendication 1, dans lequel lesdits blocs de logique combinatoire (B0, B1, ...,

Bm) comportent chacun un ou plusieurs éléments d'addition (SA) ou éléments de soustraction (SS).

**4.** Dispositif logique numérique selon la revendication 3, dans lequel une ou plusieurs interconnexions sont assurées entre l'un des éléments d'addition et/ou des éléments de soustraction des blocs de logique combinatoire (B0 B1, ..., Bm) afin de partager les éléments d'addition et/ou les éléments de soustraction respectivement en fonction desdites une ou plusieurs interconnexions et de minimiser ainsi le nombre d'éléments d'addition et/ou d'éléments de soustraction requis pour la mise en oeuvre du filtre numérique ou de la structure de logique combinatoire/séquentielle et, par conséquent, de minimiser une surface dudit dispositif logique numérique sur laquelle lesdits blocs de logique combinatoire (B0, B1, ..., Bm) sont disposés.

**5.** Dispositif logique numérique selon la revendication 3, dans lequel lorsque l'un des coefficients à produire est proche d'une puissance de deux, mais inférieur à celle-ci, un ou plusieurs éléments de soustraction en série sont utilisés de manière à produire ledit coefficient.

**6.** Filtre numérique comprenant un dispositif logique numérique produisant des coefficients de filtre, dans lequel ledit dispositif logique numérique est un dispositif logique numérique selon l'une quelconque des précédentes revendications 1 à 5.

**7.** Structure à logique combinatoire/séquentielle destinée à réaliser des opérations telles que des additions et/ou des soustractions et/ou des multiplications et/ou de production de retard, ladite structure de logique combinatoire/séquentielle comprenant un dispositif logique numérique produisant des coefficients destinés à réaliser lesdites opérations, dans laquelle ledit dispositif logique numérique est un dispositif logique numérique selon l'une quelconque des précédentes revendications 1 à 5.

## FIGURE 1.

### FIR filter

### IIR filter

## Other Application (Combination, sequential logic minimization)

Any logic comprising of elements/operations shown here

Block (A)

## FIR/IIR filter equation

$$Y(z) = X(z) \, [c(0) + c(1) \, Z^{-1} + c(2) \, Z^{-2} + c(3) \, Z^{-2} + ..... + c(n) \, Z^{-n}] \qquad ....\text{FIR Eq}$$

$$Y(z) = X(z) \; \frac{[c(0) + c(1) \, Z^{-1} + c(2) \, Z^{-2} + c(3) \, Z^{-2} + ..... + c(n) \, Z^{-n}]}{[1 - (b(1) \, Z^{-1} + b(2) \, Z^{-2} + b(3) \, Z^{-2} + ..... + b(m) \, Z^{-m})]} \qquad ....\text{IIR Eq}$$

where $X(z)$-input signal, $Z^{-1} * X(z)$ - delayed signal by one delay, $Y(z)$-output signal $c(0)$, $c(1)$, $c(2)$.......$c(n)$, $b(1)$, $b(2)$......$b(m)$ are integer coefficients values.

FIGURE 2.

Unit Delay

$x(nT)$ → [ T ] → $y(nT)$     $y(nT) = x(nT - T)$

Full adder

A
B     FA     Sum
Cin          Cout

$Sum = A + B + Cin$

$Carryout = Cout$

Full subtractor

A(+)
B(-)   FS    Diff
Cin           Cout

$Diff = A - B - Cin$

$Borrow\text{-}out = Cout$

Serial adder

$x_1(nt)$
$x_2(nT)$  → ( SA ) → $y(nT)$     $y(nT) = x_1(nT) + x_2(nT)$

Serial subtractor

$x_1(nt)$
$x_2(nT)$  → ( SS (-) ) → $y(nT)$     $y(nT) = x_1(nT) - x_2(nT)$

Multiplier

m

$x(nT)$ → ( M ) → $y(nT)$     $y(nT) = m * x(nT)$

Delay

Input Frame size = X bits (e.g input is 1010101 or X=7 bits)

To store X bit frame. number of T element used is X or 7 in present case

Serial one bit Input
Frame size (X bits)  → [ $Z^{-1}$ ] →  Serial one bit Output
Frame size (X bits)

Serial one bit Input          OR          $Eq\; y(n) = x(n-1)$
Frame size (X bits)
→ [ T | T | T | T — T | T | T ] →

# FIGURE 3.
## Unit Delay

x(nT) ——(0101011)——→ [D  T  Q] ——(01010110)——→ output

clock ——→ CLK

Input frame Input pattern (0101011) is coming serially at x(nT) pin at clock rate specified on clock pin

## Full adder (FA) / Full subtractor (FS)

binary addition/subtraction components is realized using following truth table

Truth table - Full adder

| A | B | Cin | Z | Co |
|---|---|---|---|---|
| 0 | 0 | 0 | 0 | 0 |
| 0 | 0 | 1 | 1 | 0 |
| 0 | 1 | 0 | 1 | 0 |
| 0 | 1 | 1 | 0 | 1 |
| 1 | 0 | 0 | 1 | 0 |
| 1 | 0 | 1 | 0 | 1 |
| 1 | 1 | 0 | 0 | 1 |
| 1 | 1 | 1 | 1 | 1 |

Truth table - Full Subtractor

| A | B | Cin | Z | Co |
|---|---|---|---|---|
| 0 | 0 | 0 | 0 | 0 |
| 0 | 0 | 1 | 1 | 1 |
| 0 | 1 | 0 | 1 | 1 |
| 0 | 1 | 1 | 0 | 1 |
| 1 | 0 | 0 | 1 | 0 |
| 1 | 0 | 1 | 0 | 0 |
| 1 | 1 | 0 | 0 | 0 |
| 1 | 1 | 1 | 1 | 1 |

## Serial Adder(SA) / Subtractor (SS)

## Serial Multiplier(M)

m=331 ( integer)

Bit Multiplier Coefficient size in this example is 331 (binary 101001011)

## FIGURE 4.

### Implementation 1

Input

CLin_n        CLin_2       CLin_1       CLin_0

Block (A)    Coefficient block

$c(n)$ (M)  ......  (M)  $c(2)$ (M)  $c(1)$ (M)  $c(0)$ (M)

CLout_n        CLout_2      CLout_1     CLout_0

Block (E)  $Z^{-1}$ (SA) $Z^{-1}$ (SA) $Z^{-1}$ (SA) $Z^{-1}$ (SA)

### Realization of coefficient using share-able multiplier (coeff. = 3,11)

Input    T | T | T

(SA) &rarr; (SA)

Input * 3    Input * 11

### Implementation 2

Block (E)

Input  $Z^{-1}$  $Z^{-1}$  $Z^{-1}$  $Z^{-1}$  — —  $Z^{-1}$

CLin_0  CLin_1  CLin_2             CLin_n

$c(0)$ (M) $c(1)$ (M) $c(2)$ (M) $c(3)$ (M) ....(M)  $c(n)$ (M)

(SA) &rarr; (SA) &rarr; (SA) &rarr; (SA) — — — &rarr; (SA)

Block (A)    Coefficient block

FIGURE 5.

FIGURE 6.

Begin: Using the property of symmetrical coefficient

FIGURE 7.

Block (A)

FIGURE 8.

A) Approx. Number of SA = number of coefficient * max coeff size /2)

B) Flip-flop (T) are not sharable
   Approx. Number of flip-flops ~ number of coeff * (max. coefficient size/2)

FIGURE 9.

FIGURE 10.

Figure 10A

Figure 10B

FIGURE 11.

FIGURE 12.

FIGURE 13.

Approx. Number of serial adders = (number of coefficient max coeff size /2)
Number of flip-flops(l) = Size of maximum coefficient